# EUROPÄISCHE PATENTSCHRIFT

(11) **EP 2 093 530 B1**
(45) Veröffentlichungstag und Bekanntmachung des Hinweises auf die Patenterteilung: **08.08.2012**
(21) Anmeldenummer: 09002029.8
(22) Anmeldetag: 13.02.2009
(51) Int. Cl.: F27B 14/08, F27D 9/00, C30B 35/00

(54) **Vorrichtung zum Schmelzen insbesondere von Metallen**
Device for melting, in particular metals
Dispositif de fonte, notamment de métaux

(30) Priorität: 13.02.2008 DE 102008008993
(43) Veröffentlichungstag der Anmeldung: 26.08.2009
(60) Teilanmeldung: 12001743.9
(73) Patentinhaber: ALD Vacuum Technologies GmbH, 63450 Hanau (DE)
(72) Erfinder: Popov, Ivaylo, 63452 Hanau (DE); Niebling, Arno, 63589 Linsengericht (DE); Borhau, Heiko, 63607 Wächtersbach (DE)
(74) Vertreter: Hebing, Norbert

(56) Entgegenhaltungen:
- DE-B- 1 093 926

## Beschreibung

Die Erfindung betrifft eine Vorrichtung zum Schmelzen insbesondere von Metallen mit einem Tiegel und einem den Tiegel koaxial umgebenden hohlzylinderförmigen Leitblech, so dass zwischen der zylindrischen Außenwand des Tiegels und der Innenwand des Leitbleches ein Ringspalt gebildet ist, der der Führung eines Kühlfluids dient.

Solche Vorrichtungen werden auch als Schmelzstationen bezeichnet, die in Vakuumlichtbogenöfen und Elektroschlackenumschmelzanlagen zum Einsatz kommen.

Eine derartige Vorrichtung ist in der DE 1 093 926 C beschrieben. Der Tiegel ist in einem Kühltopf angeordnet, dessen Boden über einen zentralen Zufluss und einen seitlich angeordneten Abfluss für ein Kühlfluid verfügt. Das Leitblech befindet sich zwischen dem Tiegel und dem Kühltopf, so dass das Kühlfluid innerhalb des Leitbleches an der Außenseite des Tiegels, also im Ringspalt zwischen der zylindrischen Außenwand des Tiegels und der Innenwand des Leitbleches, nach oben und außerhalb des Leitbleches an der Innenseite des Kühltopfes zurückfließen kann. Für eine ausreichende Kühlung kann die Breite des Ringspaltes relativ klein sein und z. B. zwischen 5 und 12 mm liegen. Dies hat den Vorteil, dass wegen der geringen Querschnittsfläche des Ringspaltes nur wenig Kühlfluid gefördert und damit hierfür nur wenig Leistung aufgebracht werden braucht. Bei einem notwendig werdenden Ersatz des Tiegels zeigt sich aber auch ein Nachteil. Da der Ersatztiegel aus fertigungstechnischen Gründen häufig nicht denselben Außendurchmesser aufweist wie der zu ersetzende Tiegel, ändert sich die Breite des Ringspaltes, so dass dieser entweder zu eng oder zu breit wird. Die Ringspaltbreite hat aber einen entscheidenden Einfluss auf die Geschwindigkeit des Kühlfluids. In beiden Fällen verringert sich daher die Kühlleistung, so dass unter Umständen auch ein Ersatz des Leitbleches notwendig wird, um die alte Breite des Ringspaltes wieder herzustellen.

Die Erfindung beruht somit auf der Aufgabe, die Kühlung des Tiegels so zu gestalten, dass auch bei einem Ersatz des Tiegels durch einen Tiegel mit einem vom Sollmaß abweichenden Durchmesser die Kühlleistung erhalten bleibt.

Zur Lösung der Aufgabe sieht die Erfindung vor, dass das Leitblech aus zwei halbzylindrischen Schalen besteht, die an ihren Längskanten lösbar miteinander verbunden sind, und dass im Ringspalt sich an der Außenwand des Tiegels abstützende Abstandshalter angeordnet sind, an denen die Schalen anliegen und die dadurch die Breite des Ringspaltes bestimmen.

Bei einer solchen Gestaltung passt sich der Innendurchmesser des Leitbleches dem Außendurchmesser des Tiegels an, indem das Material der Schalen entweder gedehnt oder gestaucht wird, wenn die Schalen an ihren Längskanten miteinander verbunden werden und sich dabei an die sich an der Außenwand des Tiegels abstützenden Abstandshalter anlegen. Die Breite des Ringspaltes bleibt dadurch unverändert auf Sollmaß, da er durch die Abmessungen der Abstandshalter vorgegeben wird.

Vorzugsweise sind die Abstandshalter an den Schalen befestigt.

Wenn die Abstandshalter von kurzen Rundstäben gebildet sind, die parallel zur Längsachse des Leitbleches angeordnet sind, weisen sie nur einen schmalen linearen Kontakt zum Tiegel und zum Leitblech auf, so dass der Wärmetransport über die Abstandshalter gering bleibt.

Um einen Weitertransport des von unten durch den Ringspalt fließenden Kühlfluids zu gewährleisten, sieht die Erfindung weiterhin vor, dass das Leitblech mit seinem oberen Rand an einem Ring dicht anliegt, der im oberen Bereich des Tiegels angeordnet ist und dessen Innenrand einen Abstand zur Außenwand des Tiegels einhält.

Vorzugsweise ist der Ring unterhalb und in einem Abstand zu einem am oberen Rand des Tiegels angeformten Flansch befestigt. Das Kühlfluid strömt daher durch den Ring und über dessen Oberseite zur Außenseite des Leitbleches.

Wie schon im Stand der Technik beschrieben, weist die Vorrichtung einen Kühltopf zur Aufnahme des Tiegels auf, wobei der Kühltopf einen zylindrischen Mantel und einen Boden aufweist und wobei bei einem in den Kühltopf eingesetzten Tiegel der Flansch des Tiegels auf dem oberen Rand des Kühltopfes aufliegt, so dass der Kühltopf geschlossen ist. Um den Weg des Kühlfluids innerhalb des Kühltopfes klein zu halten, weist der Kühltopf bodennah einen Wassereinlassstutzen und darüber, etwa im mittleren Bereich, einen Wasserauslassstutzen auf.

Zur Kühlung des Tiegels im Bodenbereich besteht der Boden des Tiegels aus zwei Lagen, zwischen denen Fluidkanäle ausgebildet sind, die in die Mantelfläche des Tiegels münden und die mit dem Wassereinlassstutzen in einer Fluidverbindung stehen.

Zur induktiven Heizung des Tiegels und einer sich darin befindenden Schmelze sind ein oder mehrere Spulen vorgesehen, die von einem Zwischentopf getragen werden, der zwischen dem Leitblech und dem Kühltopf angeordnet ist und der mit seinem oberen Rand gedichtet an dem Ring anliegt. Der Ring schließt dabei einen weiteren Ringspalt zwischen dem Leitblech und dem Zwischentopf, so dass der größte Teil des Kühlfluids im Wesentlichen durch den erstgenannten Ringspalt zwischen dem Leitblech und dem Tiegel fließt, dessen Breite in Hinblick auf eine gute Wärmeableitung bei einem möglichst kleinen Durchfluss des Kühlfluids optimiert ist.

Der Boden des Zwischentopfes weist eine Öffnung auf, durch die ein einen Abschnitt der Fluidverbindung bildendes Rohr hindurchgeführt ist.

Ein Teil der Tiegelwärme wird sich auch auf das Fluid in dem weiteren Ringspalt übertragen. Um einen daran angepassten geringen Abfluss des Kühlfluids aus dem weiteren Ringspalt zwischen dem Leitblech und dem Zwischentopf zu ermöglichen, ist der Ring mit Durchbrüchen zwischen seiner Unterseite und seiner Oberseite versehen, die in den weiteren Ringspalt münden. Die Durchbrüche sind dabei aber so klein, dass der Fluss durch den weiteren Ringspalt deutlich kleiner ist als durch den Ringspalt zwischen Leitblech und Tiegel.

Im Folgenden soll anhand eines Ausführungsbeispieles die Erfindung näher erläutert werden. Dazu zeigen:
- Fig.1: einen Längsschnitt durch eine Schmelzstation,
- Fig.2: einen vergrößert dargestellten Längsschnitt durch den oberen Bereich einer Schmelzstation gemäß Fig. 1,
- Fig.3: einen vergrößert dargestellten Längsschnitt durch den unteren Bereich einer Schmelzstation gemäß Fig. 1,
- Fig.4: eine Detaildarstellung aus Fig. 1,
- Fig.5: einen Querschnitt durch eine Schmelzstation gemäß Fig. 1 und
- Fig.6: eine Detaildarstellung aus Fig. 5.

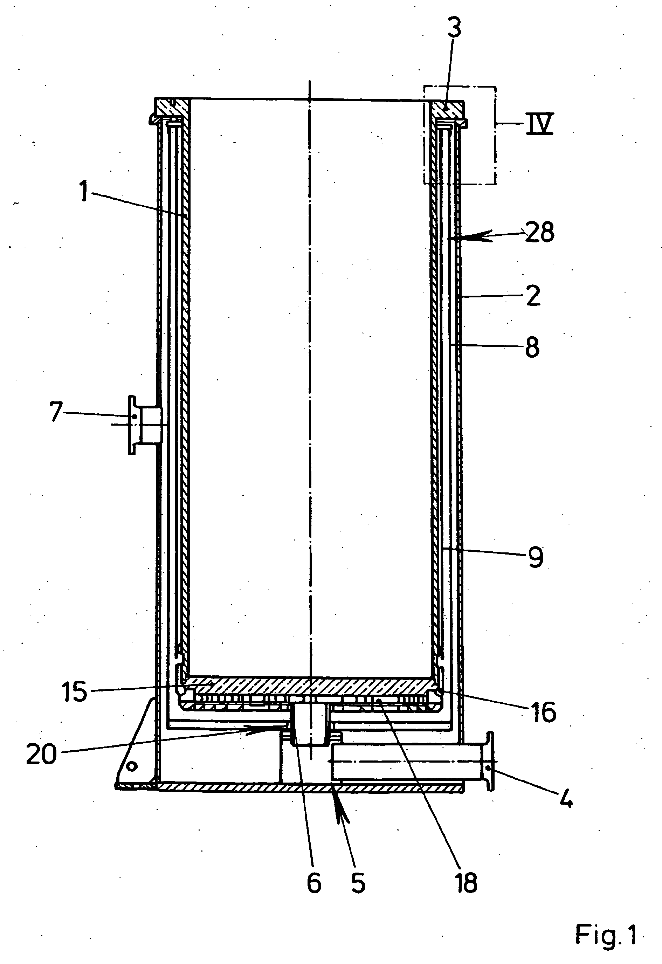

Es wird zunächst auf die Fig. 1 Bezug genommen, die eine erfindungsgemäße Vorrichtung, im Folgenden Schmelzstation genannt, zeigt. Diese besteht aus einem Tiegel 1, der in einem Kühltopf 2 angeordnet ist. Der Tiegel 1 besitzt einen Flansch 3, mit dem er auf dem oberen Rand des Kühltopfes 2 aufliegt. Zur Versorgung der Schmelzstation mit einem Kühlfluid, z. B. Wasser, ist in der Wand des Kühltopfes 2 oberhalb des Bodens ein Wassereinlassstutzen vorgesehen. Dieser führt in einen auf dem Boden des Kühltopfes 2 und in dessen Zentrum angeordneten Kasten 5, in dem von oben ein Rohr 6 eintaucht. Im mittleren Bereich der Wand des Kühltopfes 2 ist ein Wasserauslassstutzen 7 angeordnet.

Im Kühltopf befindet sich ein Zwischentopf 8, der eine hier nicht näher dargestellte Spule einer Induktionsheizung für den Tiegel 1 trägt. Der Tiegel 1 ist weiterhin eng von einem hohlzylindrischen, aus zwei Schalen bestehenden Leitblech 9 umgeben. Details dieses Aufbaus werden im Folgenden erläutert.

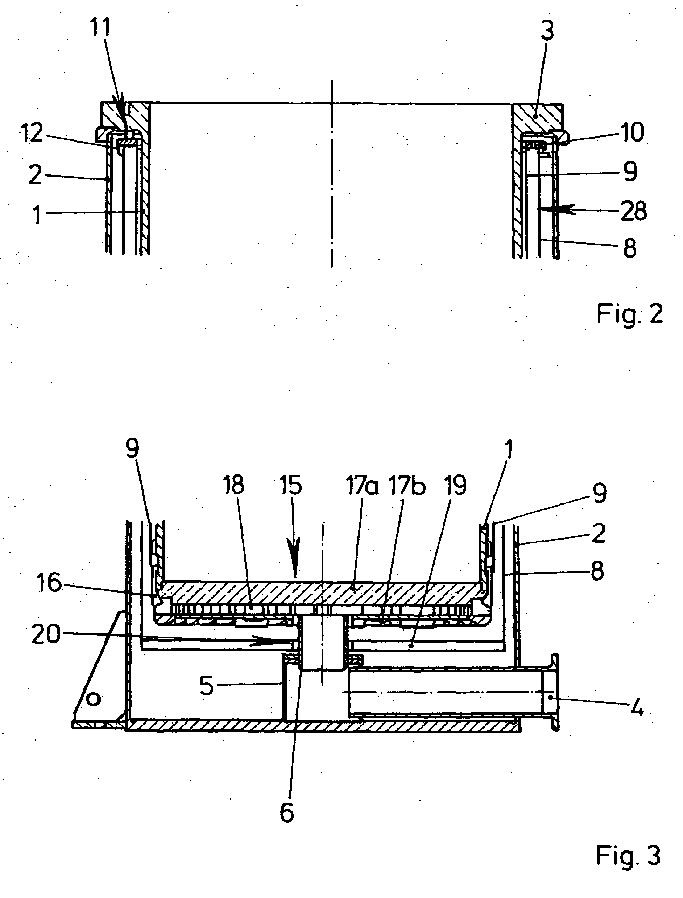

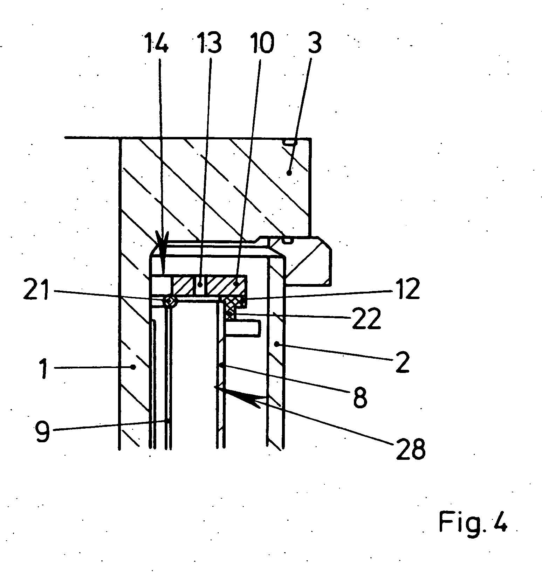

Dazu zeigt die Fig. 2 bzw. 4 den oberen Bereich der Schmelzstation. Unterhalb des Flansches 3 und in einem Abstand dazu ist ein Ring 10 mit dem Flansch 3 verschraubt. Distanzhülsen 11 sorgen für den gewünschten Abstand. An diesem Ring 10 stoßen sowohl das Leitblech 9 als auch der Zwischentopf 8 an, wobei der Stoß jeweils gedichtet ist. Ein nach unten abstehender Steg 12 sorgt für eine Zentrierung des Zwischentopfes 8. Der Ring 10 ist mit Durchbrüchen 13 in Form von Bohrungen versehen, die einen weiteren Ringspalt 28 zwischen dem Leitblech 9 und dem Zwischentopf 8 mit dem Bereich oberhalb des Ringes 10 verbinden. Der Innendurchmesser des Ringes 10 ist größer als der Außendurchmesser des Tiegels 1, so dass zwischen Ring 10 und Tiegel 1 ein Spalt 14 vorliegt.

Fig. 3 zeigt den unteren Bereich der Schmelzstation. Der Boden 15 des Tiegels 1, der an diesem mittels Klammern 16 gehalten wird, besteht aus zwei Lagen 17a, 17b, zwischen denen sich Fluidkanäle 18 befinden. Diese stehen mit dem oben schon erwähnten Rohr 6, das mit der unteren Lage 16a verbunden ist, in Fluidverbindung.

Das untere Ende des Leitbleches 9 endet im Bereich des Bodens 15.

Der Boden 19 des Zwischentopfes erstreckt sich unterhalb des Bodens 15 des Tiegels 1 und liegt auf dem Kasten 5 auf. Er weist eine zentrale Öffnung 20 auf, durch die das Rohr 6 hindurch geführt ist, so dass es in den Kasten 5 einzutauchen vermag.

Die Fig. 4 zeigt eine Detaildarstellung im Bereich des Ringes 10. Eine erste Dichtung 21 dichtet den Rand des Leitbleches 9 gegenüber dem Ring 10, so dass das Wasser, das innerhalb des Leitbleches 9 nach oben fließt, durch den Spalt 14 hindurchtreten muss. Eine zweite Dichtung 22 dichtet den Rand des Zwischentopfes 8 gegenüber dem Ring 10, so dass das Wasser, das durch den weiteren Ringspalt 28 zwischen Leitblech 9 und Zwischentopf 8 nach oben fließt, durch die Durchbrüche 13 geleitet wird.

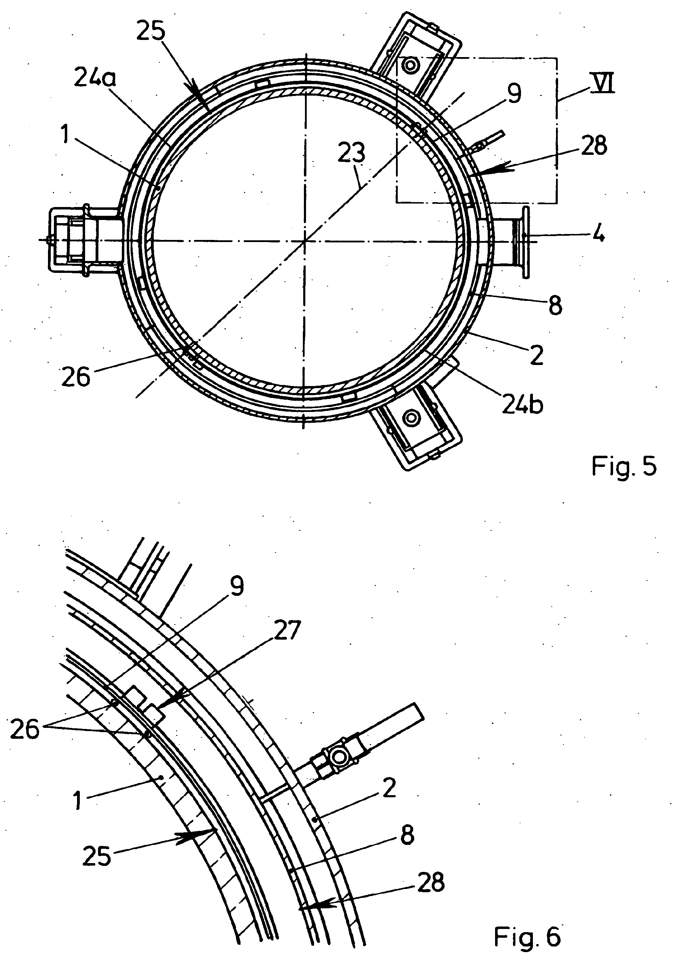

Fig. 5 zeigt einen Querschnitt durch die Schmelzstation. Man erkennt, dass das Leitblech an einer Mittelebene 23 in zwei Schalen 24a, 24b geteilt ist, die jeweils einen halben Hohlzylinder bilden, und die lösbar miteinander verbunden sind. Zwischen den Schalen 24a, 24b und dem Tiegel 1 bildet sich ein Ringspalt 25, dessen Breite durch Abstandshalter 26 bestimmt wird.

Dies ist in Fig. 6 nochmals im Detail dargestellt. Die Abstandshalter 26 sind an der Innenseite der Schalen 24a, 24b, vorzugsweise entlang deren aneinanderstoßenden Längskanten befestigt. Es handelt sich um kurze Stäbe, die vertikal, das heißt parallel zur Längsachse der Anordnung ausgerichtet sind.

Um die Schalen 24a, 24b miteinander verbinden zu können, sind auf den Außenseiten der Schalen 24a, 24b entlang deren aneinanderstoßenden Längskanten jeweils gegenüberliegend mehrere klotzartige Backen 27 geschweißt, die mittels hier nicht näher dargestellten Schrauben miteinander verschraubt sind, um die Schalen 24a, 24b zusammenzuhalten.

Bevor somit ein neuer Tiegel 1 in den Kühltopf 2 eingesetzt wird, werden die Schalen 24a, 24b vom alten Tiegel gelöst und um den neuen Tiegel 1 gelegt und miteinander verschraubt. Die an der Innenseite der Schalen 24a, 24b befestigten Abstandshalter 26 legen sich dabei an die Außenwand des Tiegels 1 an, so dass der entstehende Ringspalt 25 die gleiche Breite wie zuvor aufweist. Sollte der neue Tiegel 1 einen größeren Durchmesser aufweisen als der alte, werden die Schalen durch ein Anziehen der Schraubverbindung solange gedehnt, bis die Längskanten der Schalen 24a, 24b dicht aneinanderstoßen. Der mit einem Leitblech 9 versehene neue Tiegel 1 wird in den Kühltopf 2 eingesetzt, wobei sich der sich schon darin befindende Zwischentopf am Ring 10 ausrichtet.

### Bezugszeichenliste

- 1: Tiegel
- 2: Kühltopf
- 3: Flansch
- 4: Wassereinlassstutzen
- 5: Kasten

- 6: Rohr
- 7: Wasserauslassstutzen
- 8: Zwischentopf
- 9: Leitblech
- 10: Ring

- 11: Distanzhülsen
- 12: Steg
- 13: Durchbrüche
- 14: Spalt
- 15: Boden

- 16: Klammern
- 17a, b: Lagen
- 18: Fluidkanäle
- 19: Boden
- 20: Öffnung

- 21: erste Dichtung
- 22: zweite Dichtung
- 23: Mittelebene
- 24a, b: Schalen
- 25: Ringspalt

- 26: Abstandshalter
- 27: Backen
- 28: weiterer Ringspalt

## Patentansprüche

1. Vorrichtung zum Schmelzen insbesondere von Metallen mit einem Tiegel (1) und einem den Tiegel (1) koaxial umgebenden hohlzylinderförmigen Leitblech (9), so dass zwischen der Außenwand des Tiegels (1) und der Innenwand des Leitbleches (9) ein Ringspalt (25) gebildet ist, der der Führung eines Kühlfluids dient, **dadurch gekennzeichnet, dass** das Leitblech (9) aus zwei halbzylindrischen Schalen (24a, 24b) besteht, die an ihren Längskanten lösbar miteinander verbunden sind und dass im Ringspalt (25) sich an der Außenwand des Tiegels abstützende Abstandshalter (26) angeordnet sind, an denen die Schalen anliegen und die dadurch die Breite des Ringspaltes (25) bestimmen.

2. Vorrichtung nach Anspruch 1, **dadurch gekennzeichnet, dass** die Abstandshalter (26) an den Schalen (24a, 24b) befestigt sind.

3. Vorrichtung nach Anspruch 1 oder 2, **dadurch gekennzeichnet, dass** die Abstandshalter (26) von kurzen Rundstäben gebildet sind, die parallel zur Längsachse des Leitbleches (9) angeordnet sind.

4. Vorrichtung nach einem der vorhergehenden Ansprüche, **dadurch gekennzeichnet, dass** der Tiegel (1) in einem Kühltopf (2) angeordnet ist und einen Flansch (3) aufweist, der auf dem oberen Rand des Kühltopfes (2) aufliegt, und dass das Leitblech (9) mit seinem oberen Rand an einem Ring (10) dicht anliegt, der unterhalb des Flansches (3) und in einem Abstand dazu am Flansch befestigt ist, und dessen Innenrand einen Abstand zur Außenwand des Tiegels (1) einhält.

5. Vorrichtung nach Anspruch 4, **dadurch gekennzeichnet, dass** der Ring (10) unterhalb und in einem Abstand zu einem am oberen Rand des Tiegels (1) angeformten Flansch (3) befestigt ist.

6. Vorrichtung nach Anspruch 5, **dadurch gekennzeichnet, dass** die Vorrichtung einen Kühltopf (2) zur Aufnahme des Tiegels (1) aufweist, wobei der Kühltopf (2) einen zylindrischen Mantel und einen Boden (15) aufweist, und wobei bei einem in den Kühltopf (2) eingesetzten Tiegel (1) der Flansch (3) des Tiegels (1) auf dem oberen Rand des Kühltopfes (2) aufliegt, so dass der Kühltopf (2) geschlossen ist, und dass der Kühltopf (2) bodennah einen Wassereinlassstutzen (4) und darüber einen Wasserauslassetutzen (7) aufweist.

7. Vorrichtung nach Anspruch 6, **dadurch gekennzeichnet, dass** der Boden (15) des Tiegels (1) aus zwei Lagen (17a, 17b) besteht, zwischen denen Fluidkanäle (18) ausgebildet sind, die in die Mantelfläche des Tiegels (1) münden und die mit dem Wassereinlassstutzen (4) in einer Fluidverbindung stehen.

8. Vorrichtung nach Anspruch 5, **dadurch gekennzeichnet, dass** zwischen dem Leitblech (9) und dem Kühltopf (2) ein Zwischentopf (8) angeordnet ist, der mit seinem oberen Rand gedichtet an dem Ring (10) anliegt.

9. Vorrichtung nach Anspruch 8, **dadurch gekennzeichnet, dass** der Boden (19) des Kühltopfes (2) eine Öffnung (20) aufweist, durch die ein einen Abschnitt der Fluidverbindung bildendes Rohr (6) hindurchgeführt ist.

10. Vorrichtung nach Anspruch 8, **dadurch gekennzeichnet, dass** der Ring (10) mit Durchbrüchen (13) zwischen seiner Unterseite und seiner Oberseite versehen ist, die in einen weiteren Ringspalt (28) zwischen dem Leitblech (9) und dem Zwischentopf (8) münden.

## Claims

1. A device for melting, in particular metals, with a crucible (1) and a hollow-cylindrical guide plate (9) that coaxially surrounds the crucible (1) such that an annular gap (25) for a cooling fluid is formed between the outer wall of the crucible (1) and the inner wall of the guide plate (9), **characterized in that** the guide plate (9) consists of two semi-cylindrical bowls (24a, 24b) that are separably connected to one another on their longitudinal edges, and **in that** spacers (26) are arranged in the annular gap (25) and supported on the outer wall of the crucible, wherein the bowls adjoin said spacers and thereby define the width of the annular gap (25).

2. The device according to Claim 1, **characterized in that** the spacers (26) are fixed on the bowls (24a, 24b).

3. The device according to Claim 1 or 2, **characterized in that** the spacers (26) consist of short round rods that are arranged parallel to the longitudinal axis of the guide plate (9).

4. The device according to one of the preceding claims, **characterized in that** the crucible (1) is arranged in a cooling pot (2) and features a flange (3) that adjoins the upper edge of the cooling pot (2), and **in that** the upper edge of the guide plate (9) tightly adjoins a ring (10) that is fixed on the flange underneath the flange (3), as well as at a distance from said flange, and the inner wall of which maintains a distance from the outer wall of the crucible (1).

5. The device according to Claim 4, **characterized in that** the ring (10) is fixed underneath and at a distance from a flange (3) formed onto the upper edge of the crucible (1).

6. The device according to Claim 5, **characterized in that** the device features a cooling pot (2) for accommodating a crucible (1), wherein the cooling pot (2) features a cylindrical shell and a bottom (15), and wherein the flange (3) of the crucible (1) rests on the upper edge of the cooling pot (2) when a crucible (1) is inserted into the cooling pot (2) such that the cooling pot (2) is closed, and **in that** the cooling pot (2) features a water inlet connection (4) near the bottom and a water outlet connection (7) arranged above the water inlet connection.

7. The device according to Claim 6, **characterized in that** the bottom (15) of the crucible (1) consists of two layers (17a, 17b), between which fluid channels (18) are formed that lead into the surface shell of the crucible (1) and are fluidically connected to the water inlet connection (4).

8. The device according to Claim 5, **characterized in that** an intermediate pot (8) is arranged between the guide plate (9) and the cooling pot (2) and adjoins the ring (10) with its upper edge in a sealed fashion.

9. The device according to Claim 8, **characterized in that** the bottom (19) of the cooling pot (2) features an opening (20), through which a pipe (6) forming a section of the fluidic connection is routed.

10. The device according to Claim 8, **characterized in that** the ring (10) is provided with apertures (13) between its lower side and its upper side, wherein said apertures lead into another annular gap (28) between the guide plate (9) and the intermediate pot (8).

## Revendications

1. Dispositif de fonte, en particulier de métaux, comportant un creuset (1) et une tôle de chicane en forme de cylindre creux (9) entourant coaxialement le creuset (1) de manière à former entre la paroi extérieure du creuset (1) et la paroi intérieure de la tôle de chicane (9) une fente annulaire (25) qui sert de guide à un fluide de refroidissement, **caractérisé en ce que** la tôle de chicane (9) est composée de deux coques demi-cylindriques (24a, 24b) qui sont raccordées l'une à l'autre de manière dissociable par leurs arêtes longitudinales et que des espaceurs (26) s'appuyant dans la fente annulaire (25) sont disposés sur la paroi extérieure du creuset, espaceurs sur lesquels reposent les coques et qui déterminent ainsi la largeur de la fente annulaire (25).

2. Dispositif selon la revendication 1, **caractérisé en ce que** les espaceurs (26) sont fixés aux coques (24a, 24b).

3. Dispositif selon la revendication 1 ou 2, **caractérisé en ce que** les espaceurs (26) sont constitués de barreaux courts qui sont disposés parallèlement à l'axe longitudinal de la tôle de chicane (9).

4. Dispositif selon une des revendications précédentes, **caractérisé en ce que** le creuset (1) est disposé dans une cuve de refroidissement (2) et présente une bride (3) qui repose sur le bord supérieur de la cuve de refroidissement (2) et que la tôle de chicane (9) repose étroitement par son bord supérieur sur un anneau (10) qui est fixé au-dessous de la bride (3) et à distance de celle-ci sur la bride et dont le bord intérieur respecte une distance par rapport à la paroi extérieure du creuset (1).

5. Dispositif selon la revendication 4, **caractérisé en ce que** l'anneau (10) est fixé au-dessous et à distance d'une bride (3) formée au niveau du bord supérieur du creuset (1).

6. Dispositif selon la revendication 5, **caractérisé en ce que** le dispositif présente une cuve de refroidissement (2) destinée à recevoir le creuset (1), la cuve de refroidissement (2) présentant une enveloppe cylindrique et un fond (15) et, pour un creuset (1) inséré dans la cuve de refroidissement (2), la bride (3) du creuset (1) reposant sur le bord supérieur de la cuve de refroidissement (2) de manière à ce que la cuve de refroidissement (2) soit fermée, et que la cuve de refroidissement (2) présente près de son fond une tubulure d'admission d'eau (4) et par-dessus une tubulure d'évacuation d'eau (7).

7. Dispositif selon la revendication 6, **caractérisé en ce que** le fond (15) du creuset (1) consiste en deux épaisseurs (17a, 17b) entre lesquelles sont réalisés des canaux à fluide (18) qui débouchent dans la surface d'enveloppe du creuset (1) et qui sont en liaison de fluide avec la tubulure d'admission d'eau (4).

8. Dispositif selon la revendication 5, **caractérisé en ce que**, entre la tôle de chicane (9) et la cuve de refroidissement (2), est disposée une cuve intermédiaire (8) qui repose hermétiquement par son bord supérieur sur l'anneau (10).

9. Dispositif selon la revendication 8, **caractérisé en ce que** le fond (19) de la cuve de refroidissement (2) présente une ouverture (20) à travers laquelle passe un tuyau (6) formant une section de la liaison de fluide.

10. Dispositif selon la revendication 8, **caractérisé en ce que** l'anneau (10) est pourvu entre sa face inférieure et sa face supérieure de percées (13) qui débouchent dans une autre fente annulaire (28) entre la tôle de chicane (9) et la cuve intermédiaire (8).
